# EUROPEAN PATENT APPLICATION

(11) **EP 4 503 326 A1**
(43) Date of publication of application: **05.02.2025**
(21) Application number: 23790890.0
(22) Date of filing: 01.03.2023
(51) Int. Cl.: H01M 50/583

(54) **ADAPTER MODULE, BATTERY MODULE, BATTERY PACK, AND VEHICLE**

(30) Priority: 21.04.2022 CN 202210437312
(71) Applicant: BYD Company Limited, Shenzhen, Guangdong 518118 (CN)
(72) Inventor: HU, Shichao, Shenzhen, Guangdong 518118 (CN); CHEN, Jianen, Shenzhen, Guangdong 518118 (CN); ZHANG, Yaosheng, Shenzhen, Guangdong 518118 (CN); GAO, Jian, Shenzhen, Guangdong 518118 (CN)
(74) Representative: Taor, Simon Edward William
(86) International application number: PCT/CN2023/079067
(87) International publication number: WO 2023/202227

(57) **Abstract**

An adapter module (1), a battery module (2), a battery pack (3), and a vehicle (4). The adapter module (1) comprises a support member (10), a low-voltage plug member (20), a sampling assembly (30), and an electrode lead-out piece (40). The low-voltage plug member (20) is provided on the support member (10). One end of the sampling assembly (30) is provided on the support member; the described end of the sampling assembly (30) is electrically connected to the low-voltage plug member (20); and the sampling assembly (30) is used for voltage sampling and/or temperature sampling. The electrode lead-out piece (40) is provided on the support member (10), is spaced apart from the low-voltage plug member (20), and is electrically connected to the described end of the sampling assembly (30).

## Description

### CROSS-REFERENCE TO RELATED APPLICATIONS

The present disclosure claims priority to and benefits of Chinese Patent Application No. "202210437312.3", filed by BYD Company Limited on April 21, 2022 and entitled "ADAPTER MODULE, BATTERY MODULE, BATTERY PACK, AND VEHICLE".

### FIELD

The present disclosure relates to the field of vehicle technologies, and specifically, to an adapter module, a battery module, a battery pack, and a vehicle.

### BACKGROUND

In the related art, an adapter module is generally provided as a ceramic cover structure, and is formed by a cover body, a positive terminal, a negative terminal, a positive lead-out piece, a negative lead-out piece, a ceramic terminal, a plug member, and a sampling assembly. However, the adapter module has a large number of parts and low integration, resulting in high costs and many inconveniences in use.

### SUMMARY

The present disclosure is intended to resolve at least one of the technical problems existing in the related art. Therefore, the present disclosure provides an adapter module. The adapter module can improve integration of the adapter module, reduce unnecessary components, reduce manufacturing costs of the adapter module, and facilitate plugging and fitting between the adapter module and an external component, so that a sampling assembly can better sample battery cores.

The present disclosure further provides a battery module using the foregoing adapter module.

The present disclosure still further provides a battery pack using the foregoing battery module.

The present disclosure yet further provides a vehicle using the foregoing battery pack.

An adapter module according to an embodiment of a first aspect of the present disclosure includes a support member, a low-voltage plug member, a sampling assembly, and an electrode lead-out piece. The low-voltage plug member is provided on the support member. One end of the sampling assembly is arranged on the support member. The one end of the sampling assembly is electrically connected to the low-voltage plug member. The sampling assembly is configured to perform voltage sampling and/or temperature sampling. The electrode lead-out piece is provided on the support member, spaced apart from the low-voltage plug member, and electrically connected to the one end of the sampling assembly.

In the adapter module according to this embodiment of the present disclosure, the low-voltage plug member, the one end of the sampling assembly, and the electrode lead-out piece are all provided on the support member, so that integration of the adapter module can be improved, and unnecessary components can be reduced, thereby reducing manufacturing costs of the adapter module. In addition, such an arrangement facilitates plugging and fitting between the adapter module and an external component, and the sampling assembly can better sample battery cores.

In an embodiment, the electrode lead-out piece is snap-fitted with the support member.

In an embodiment, the support member includes an outer frame, a support body, and a positioning body. The support body is arranged in a middle of the outer frame. The positioning body is arranged at edges of the outer frame. The positioning body is located on two sides of the support body respectively. The electrode lead-out piece includes a positive lead-out piece and a negative lead-out piece. One part of the positive lead-out piece and one part of the negative lead-out piece are respectively positioning-fitted with the corresponding positioning body. An other part of the positive lead-out piece and an other part of the negative lead-out piece are respectively snap-fitted with the two sides of the support body.

In an embodiment, the electrode lead-out piece further includes an inner connecting piece, a connecting piece, and an outer connecting piece. The connecting piece is bent and connected between the inner connecting piece and the outer connecting piece. The outer connecting piece is positioning-fitted with the positioning body. A first snap-connecting piece is arranged on the inner connecting piece. A second snap-connecting piece is arranged on a side surface of the support body. The first snap-connecting piece is snap-fitted with the second snap-connecting piece.

In an embodiment, at least two first snap-connecting pieces are provided. The at least two first snap-connecting pieces are respectively located at two ends of the inner connecting piece along a length direction. At least two second snap-connecting pieces are provided. The at least two second snap-connecting pieces are snap-fitted with the at least two first snap-connecting pieces in a one-to-one correspondence.

In an embodiment, the first snap-connecting piece is a snap groove arranged at an end of the inner connecting piece, and the second snap-connecting piece is a snap protrusion arranged on a side surface of the support body. The snap protrusion is snap-fitted with the snap groove.

In an embodiment a third snap-connecting piece is arranged on a side surface of the support body. The third snap-connecting piece is snap-connected to an end of the outer connecting piece connected to the connecting piece.

In an embodiment, a groove is provided on a side surface of the support body. The third snap-connecting piece is an elastic snap. The elastic snap is arranged in the groove.

In an embodiment, a first positioning piece is arranged on the outer connecting piece, and a second positioning piece is arranged on the positioning body. One of the first positioning piece and the second positioning piece is a positioning column. The other of the first positioning piece and the second positioning piece is a positioning hole. The positioning column fits the positioning hole.

In an embodiment, the low-voltage plug member and the support member are integrally formed structural members. Alternatively, the support member is provided with a holder. The low-voltage plug member is fixed to the holder.

In an embodiment, the sampling assembly includes a sampling line and an electrical connection board. The electrical connection board is arranged at an end of the sampling line and is electrically connected to the low-voltage plug member. The electrical connection board is further electrically connected to the electrode lead-out piece.

A battery module according to an embodiment of a second aspect of the present disclosure includes multiple battery cores. The multiple battery cores are connected in series. In the adapter module according to the embodiment of the first aspect of the present disclosure, the support member is arranged at an end of the multiple battery cores. The electrode lead-out piece is connected to electrodes corresponding to battery cores at a head end and a tail end respectively. The sampling assembly is arranged on one side of the multiple battery cores, to perform voltage sampling and/or temperature sampling.

A battery pack according to an embodiment of a third aspect of the present disclosure includes the battery module according to the embodiment of the second aspect of the present disclosure.

A vehicle according to an embodiment of a fourth aspect of the present disclosure includes the battery pack according to the embodiment of the third aspect of the present disclosure.

Additional aspects and advantages of the present disclosure are partially provided in the following description, and partially become apparent in the following description or understood through the practice of the present disclosure.

### BRIEF DESCRIPTION OF THE DRAWINGS

The foregoing and/or additional aspects and advantages of the present disclosure become apparent and comprehensible in the description made with reference to the following accompanying drawing, wherein:
FIG. 1 is a schematic structural diagram of an adapter module according to an embodiment of the present disclosure;
FIG. 2 is a schematic partial structural diagram of an adapter module according to an embodiment of the present disclosure;
FIG. 3 is an exploded view of an adapter module according to an embodiment of the present disclosure;
FIG. 4 is a schematic structural diagram of a battery module according to another embodiment of the present disclosure; and
FIG. 5 is a schematic diagram of a vehicle according to an embodiment of the present disclosure.

List of reference numerals:
1. adapter module;
10. support member; 11. outer frame; 12. support body; 13. positioning body; 14. second snap-connecting piece; 15. third snap-connecting piece; 16. groove; 17. second positioning piece; 18. holder; 20. low-voltage plug member; 30. sampling assembly; 31. sampling line; 32. electrical connection board; 40. electrode lead-out piece; 41. positive lead-out piece; 42. negative lead-out piece; 43. inner connecting piece; 44. connecting piece; 45. outer connecting piece; 46. first snap-connecting piece; 47. first positioning piece; 2. battery module; 50. battery core; 3. battery pack; 4. vehicle.

### DETAILED DESCRIPTION

Embodiments of the present disclosure are described below in detail, and examples of the embodiments are shown in accompanying drawings, where the same or similar elements or the elements having same or similar functions are denoted by the same or similar reference numerals throughout the description. The embodiments described below with reference to the accompanying drawings are exemplary, and are intended to explain the present disclosure and cannot be construed as a limitation to the present disclosure.

In the description of the present disclosure, it should be understood that, orientations or position relationships indicated by terms, such as "center", "up", "down", "front", "back", "left", "right", "vertical", "horizontal", "top", "bottom", "in", and "out", re orientations or position relationships shown based on the accompanying drawings. These terms are merely for the convenience of describing the present disclosure and simplifying the description, and not to indicate or imply that the apparatus or element referred to needs to have a particular orientation, be constructed and operated in a particular orientation, and therefore cannot be understood as a limitation on the present disclosure.

It should be noted that the terms "first" and "second" are used for descriptive purposes only and should not be construed as indicating or implying relative importance or implicitly indicating the number of technical features indicated. Therefore, features defining "first" and "second" may explicitly or implicitly include one or more such features. Further, in the description of the present disclosure, unless otherwise stated, "multiple" means two or more than two.

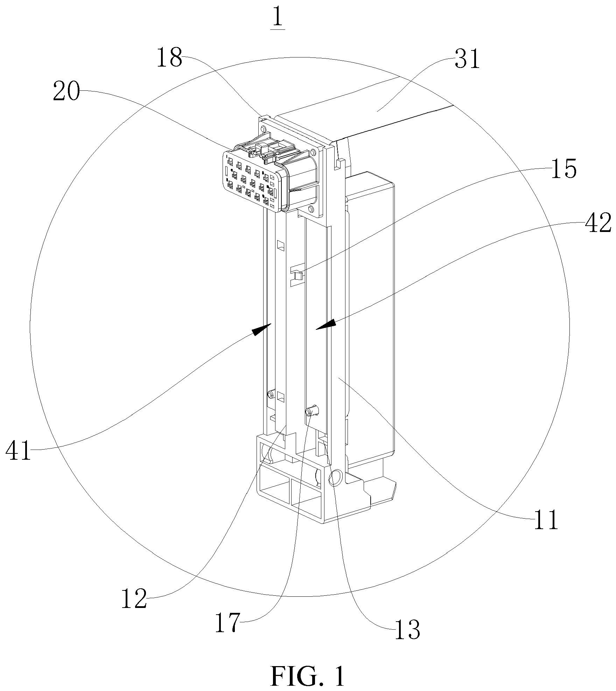

An adapter module 1 and a battery module 2 according to the embodiments of the present disclosure are described below with reference to FIG. 1 to FIG. 4. The adapter module 1 is arranged on the battery module 2. The battery module 2 is provided with a battery core 50. The adapter module 1 may adapt an output signal and/or an input signal of the battery core 50, for example, may convert a current, to convert an input and/or an output of the current between a direct current and an alternating current, which enables the battery core 50 to normally operate.

As shown in FIG. 1 to FIG. 3, an adapter module 1 according to an embodiment of a first aspect of the present disclosure includes a support member 10, a low-voltage plug member 20, a sampling assembly 30, and an electrode lead-out piece 40. The support member 10 may implement a supporting function. Generally, the support member 10 is arranged on a battery core 50, to facilitate a connection between the overall adapter module 1 and the battery core 50. The low-voltage plug member 20 is mainly configured to plug-connect to an external component, so that the battery core 50 can transmit a signal to the external component. The support member 10 may be a support member 10 made of plastic.

The sampling assembly 30 may sample the battery core 50. Specifically, the sampling assembly 30 may be configured to perform voltage sampling and/or temperature sampling. In this way, the sampling assembly 30 can collect voltage and temperature information of the battery core 50 in real time, and compare the collected voltage and temperature information with normal values, to protect the battery core 50 and ensure normal operation of the battery core 50. Certainly, the sampling assembly 30 is not limited to collecting voltage and temperature information of the battery core 50, and for example, may also collect current information between battery cores 50. In addition, the electrode lead-out piece 40 may be connected to the battery core 50, to facilitate an electrical connection between the battery core 50 and another component.

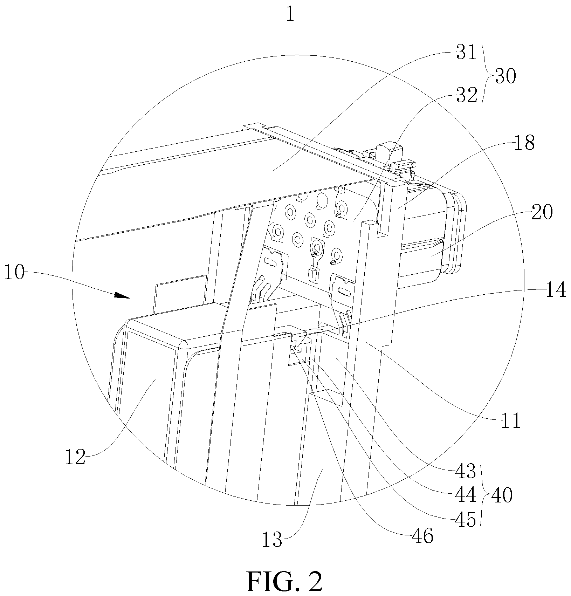

As shown in FIG. 1 and FIG. 2, the low-voltage plug member 20 is provided on the support member 10. One end of the sampling assembly 30 is provided on the support member 10. The one end of the sampling assembly 30 is electrically connected to the low-voltage plug member 20. The electrode lead-out piece 40 is provided on the support member 10, spaced apart from the low-voltage plug member 20, and electrically connected to the one end of the sampling assembly 30. In other words, the electrode lead-out piece 40 is provided on the support member 10, connected to the battery core 50, and electrically connected to the one end of the sampling assembly 30. In this way, the sampling assembly 30 can be connected to the battery core 50 by the electrode lead-out piece 40, to sample the battery core 50, thereby ensuring normal operation of the battery core 50. The one end of the sampling assembly 30 is provided on the support member 10, and the one end of the sampling assembly 30 is electrically connected to the low-voltage plug member 20. In this way, the low-voltage plug member 20 may further be electrically connected to the battery core 50 by the sampling assembly 30, and therefore, may transmit a signal to the battery core 50. In addition, the electrode lead-out piece 40 is spaced apart from the low-voltage plug member 20, which can facilitate arrangement, and can prevent interference between the electrode lead-out piece 40 and the low-voltage plug member 20 from affecting normal operation of the adapter module 1.

Therefore, the low-voltage plug member 20, the one end of the sampling assembly 30, the electrode lead-out piece 40, and the low-voltage plug member 20 are all provided on the support member 10, so that integration of the adapter module 1 can be improved, and unnecessary components can be reduced, thereby reducing manufacturing costs of the adapter module 1. In addition, such an arrangement facilitates plugging and fitting between the adapter module 1 and the external component, and the sampling assembly 30 can better sample the battery core 50.

Optionally, as shown in FIG. 1 and FIG. 2, the electrode lead-out piece 40 is snap-fitted with the support member 10. The electrode lead-out piece 40 and the support member 10 may be fitted with each other in a snap-connection manner. In this way, a connection between the electrode lead-out piece 40 and the support member 10 may be firmer and more reliable. In addition, through the snap-connection manner, it is simpler and more convenient to assemble the electrode lead-out piece 40 and the support member 10, thereby improving assembly efficiency.

Specifically, as shown in FIG. 1 to FIG. 3, the support member 10 includes an outer frame 11, a support body 12, and a positioning body 13. The support body 12 is arranged in a middle of the outer frame 11. The positioning body 13 is arranged at edges of the outer frame 11. The positioning body 13 is located on two sides of the support body 12 respectively. The electrode lead-out piece 40 includes a positive lead-out piece 41 and a negative lead-out piece 42. One part of the positive lead-out piece 41 and one part of the negative lead-out piece 42 are respectively positioning-fitted with the corresponding positioning body 13. An other part of the positive lead-out piece 41 and an other part of the negative lead-out piece 42 are respectively snap-fitted with the two sides of the support body 12.

The outer frame 11 can implement an installation function. The support body 12 is a main part of the support member 10, and can implement a supporting function. Moreover, the positioning body 13 can implement a positioning function. The positive lead-out piece 41 and the negative lead-out piece 42 are connected to a positive pole and a negative pole of the battery core 50 respectively, so that the battery core 50 can transmit a signal. The support body 12 is arranged in the middle of the outer frame 11. In this way, the outer frame 11 leaves installation space on the two sides of the support body 12. In addition, the positioning body 13 is arranged at the edges of the outer frame 11, and the positioning body 13 is respectively located on the two sides of the support body 12. In this way, during installation of the positive lead-out piece 41 and the negative lead-out piece 42, at least parts thereof need to be positioning-fitted with the corresponding positioning body 13. In this way, it is convenient to install the positive lead-out piece 41 and the negative lead-out piece 42 in alignment, and positions of the positive lead-out piece 41 and the negative lead-out piece 42 can be fixed to some extent. In addition, the other part of the positive lead-out piece 41 and the other part of the negative lead-out piece 42 are further respectively snap-fitted with the two sides of the support body 12. In this way, the positive lead-out piece 41 and the negative lead-out piece 42 can be further fixed, so that a connection between the positive lead-out piece 41 and the support member 10 and a connection between the negative lead-out piece 42 and the support member 10 are more stable and reliable.

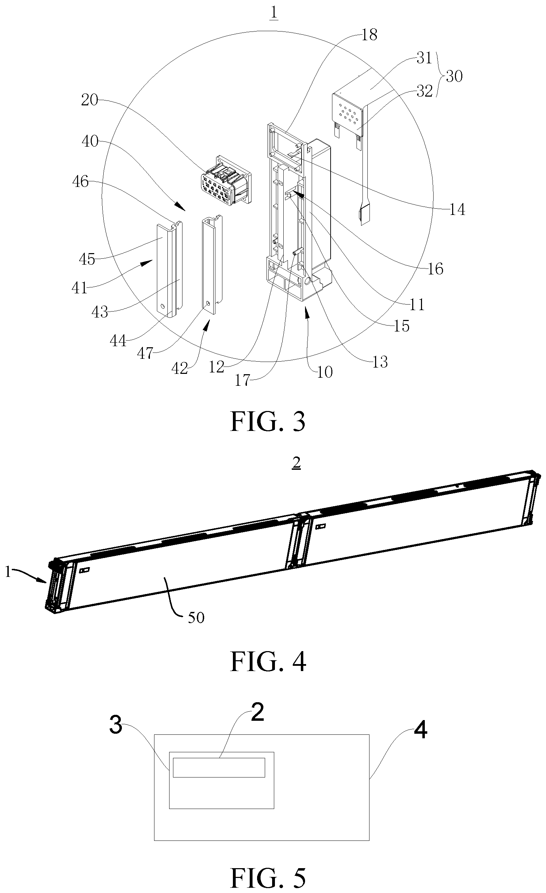

It should be noted that, as shown in FIG. 2 and FIG. 3, the electrode lead-out piece 40 further includes an inner connecting piece 43, a connecting piece 44, and an outer connecting piece 45. The connecting piece 44 is bent and connected between the inner connecting piece 43 and the outer connecting piece 45. The outer connecting piece 45 is positioning-fitted with the positioning body 13. A first snap-connecting piece 46 is arranged on the inner connecting piece 43, and a second snap-connecting piece 14 is arranged on a side surface of the support body 12. The first snap-connecting piece 46 is snap-fitted with the second snap-connecting piece 14. The connecting piece 44 can implement a connection function. The connecting piece 44 is connected between the inner connecting piece 43 and the outer connecting piece 45. In this way, the electrode lead-out piece 40 can be connected into a whole, which facilitates overall installation and arrangement of the electrode lead-out piece 40. Moreover, the connecting piece 44 is bent and arranged. In this way, the structure of the electrode lead-out piece 40 can fit the structure of the support member 10, and can be better fixed to the support member 10.

The outer connecting piece 45 is positioning-fitted with the positioning body 13. In this way, it is convenient to install the electrode lead-out piece 40 and the support member 10 in alignment, which can implement a foolproof function, and can fix positions of the positive lead-out piece 41 and the negative lead-out piece 42 to some extent. A first snap-connecting piece 46 is arranged on the inner connecting piece 43, and a second snap-connecting piece 14 is arranged on a side surface of the support body 12. The first snap-connecting piece 46 may be snap-fitted with the second snap-connecting piece 14, so that the electrode lead-out piece 40 can be more firmly provided on the support member 10, and the electrode lead-out piece 40 can operate more stably.

Further, as shown in FIG. 2 and FIG. 3, at least two first snap-connecting pieces 46 are provided. The at least two first snap-connecting pieces 46 are respectively located at two ends of the inner connecting piece 43 along a length direction. At least two second snap-connecting pieces 14 are provided. The at least two second snap-connecting pieces 14 are snap-fitted with the at least two first snap-connecting pieces 46 in a one-to-one correspondence. At least two first snap-connecting pieces 46 and at least two second snap-connecting piece 14 are provided. In addition, the at least two first snap-connecting pieces 46 are respectively located at the two ends of the inner connecting piece 43 along the length direction. The at least two second snap-connecting pieces 14 are snap-fitted with the at least two first snap-connecting pieces 46 in a one-to-one correspondence. The two ends of the inner connecting piece 43 along the length direction can both be stably provided on the support member 10, thereby ensuring that the electrode lead-out piece 40 is stably provided on the support member 10.

As shown in FIG. 2 and FIG. 3, the first snap-connecting piece 46 is a snap groove provided at an end of the inner connecting piece 43, and the second snap-connecting piece 14 is a snap protrusion arranged on a side surface of the support body 12. The snap protrusion is snap-fitted with the snap groove. The first snap-connecting piece 46 is configured as a snap groove, and the second snap-connecting piece 14 is configured as a snap protrusion. The snap protrusion is snap-connected into the snap groove, so that the electrode lead-out piece 40 can be fixed to the support member 10. Moreover, the snap protrusion and the snap groove have simple structures and are easy to process. In addition, during assembly, snap-fitting between the snap protrusion and the snap groove can make the operation easier and more convenient.

In addition, as shown in FIG. 1 and FIG. 3, a third snap-connecting piece 15 is arranged on a side surface of the support body 12. The third snap-connecting piece 15 is snap-connected to an end of the outer connecting piece 45 connected to the connecting piece 44. The third snap-connecting piece 15 is arranged on the side surface of the support body 12, and the third snap-connecting piece 15 is snap-connected to the end of the outer connecting piece 45 connected to the connecting piece 44. In this way, the electrode lead-out piece 40 can be further fixed, a position of the electrode lead-out piece 40 is defined, and the electrode lead-out piece 40 is prevented from shaking or even displacement during operation, so that the electrode lead-out piece 40 can operate more stably.

Certainly, as shown in FIG. 3, a groove 16 is provided on a side surface of the support body 12, and the third snap-connecting piece 15 is an elastic snap. The elastic snap is arranged in the groove 16. It may be understood that, when the electrode lead-out piece 40 is assembled into the support member 10, the third snap-connecting piece 15 needs to be pressed first. The groove 16 is provided on the side surface of the support body 12, and the third snap-connecting piece 15 is an elastic snap. The elastic snap can be elastically deformed. When the third snap-connecting piece 15 is pressed, the third snap-connecting piece 15 can stay inside the groove 16 for avoidance, so that the electrode lead-out piece 40 can be better assembled into the support member 10. After the electrode lead-out piece 40 is assembled to the support member 10, pressure on the third snap-connecting piece 15 is released. In this case, the third snap-connecting piece 15 automatically returns to an original position due to elastic performance, thereby limiting the position of the electrode lead-out piece 40 through a snap connection.

In addition, as shown in FIG. 1 and FIG. 3, a first positioning piece 47 is arranged on the outer connecting piece 45, and a second positioning piece 17 is arranged on the positioning body 13. One of the first positioning piece 47 and the second positioning piece 17 is a positioning column, the other of the first positioning piece 47 and the second positioning piece 17 is a positioning hole. The positioning column fits the positioning hole. In other words, one of the outer connecting piece 45 and the positioning body 13 is provided with a positioning column, and the other of the outer connecting piece 45 and the positioning body 13 is provided with a positioning hole. The positioning column fits the positioning hole. In this way, a positioning and guiding function can be implemented, so that the outer connecting piece 45 can be more accurately assembled to the positioning body 13, to implement a foolproof function. In addition, positioning-fitting between the positioning column and the positioning hole can also implement a fixing function to some extent, so that the electrode lead-out piece 40 is fixed to the support member 10 relatively.

According to an optional embodiment of the present disclosure, as shown in FIG. 1 to FIG. 3, the low-voltage plug member 20 and the support member 10 are integrally formed structural members, or the support member 10 is provided with a holder 18, and the low-voltage plug member 20 is fixed to the holder 18. The low-voltage plug member 20 and the support member 10 may be integrally formed structural members. In this way, a connection between the low-voltage plug member 20 and the support member 10 is firmer, and reliability of the connection between the low-voltage plug member 20 and the support member 10 can be improved. Alternatively, the support member 10 is provided with the holder 18. The low-voltage plug member 20 may be pre-fixed to the holder 18 in a plugging manner first, and then the low-voltage plug member 20 is fixed to the holder 18 by soldering or hot melting. In this way, it is convenient to manufacture the low-voltage plug member 20 and the support member 10, and it is not prone to interference with other components during assembly of the low-voltage plug member 20 and the support member 10.

In addition, as shown in FIG. 1 to FIG. 3, the sampling assembly 30 includes a sampling line 31 and an electrical connection board 32. The electrical connection board 32 is arranged at an end of the sampling line 31. The electrical connection board 32 is electrically connected to the plug member. The electrical connection board 32 is further electrically connected to the electrode lead-out piece 40. The sampling line 31 can implement a sampling function, and the electrical connection board 32 can implement a control function. The electrical connection board 32 is arranged at an end of the sampling line 31. Information collected by the sampling line 31 may be sent to the electrical connection board 32. The electrical connection board 32 may process the information, thereby ensuring normally operation of the battery core 50. The electrical connection board 32 is electrically connected to the low-voltage plug member 20, and the electrical connection board 32 is also electrically connected to the electrode lead-out piece 40. In this way, the electrical connection board 32 can control both the low-voltage plug member 20 and the battery core 50, and can convert signals transmitted between the low-voltage plug member 20 and the battery core 50, to enable the battery core 50 to output and/or input a required signal, thereby ensuring normal operation of the battery core 50.

As shown in FIG. 4, a battery module 2 according to an embodiment of a second aspect of the present disclosure includes multiple battery cores 50 and the adapter module 1 according to the embodiment of the first aspect of the present disclosure. The multiple battery cores 50 are connected in series. The support member 10 is arranged at an end of the multiple battery cores 50. The electrode lead-out piece 40 is connected to electrodes corresponding to battery cores 50 at a head end and a tail end respectively. The sampling assembly 30 is arranged on one side of the multiple battery cores 50, to perform voltage sampling and/or temperature sampling. In other words, after the multiple battery cores 50 are connected in series, the battery cores 50 at the two ends may form a U-shaped structure, and the support member 10 may be arranged at one of the two ends. In addition, the electrode lead-out piece 40 may be connected to battery cores 50 connected end to end at the end, and an end of the sampling assembly 30 is also located at the end. In this way, during operation of the multiple battery cores 50, the sampling assembly 30 can better sample voltages and temperatures of the battery cores 50, to ensure that the multiple battery cores 50 can normally operate. Certainly, the sampling assembly 30 may also sample battery cores 50 connected end to end in the middle and battery cores 50 connected end to end at the other end.

As shown in FIG. 5, a battery pack 3 according to an embodiment of a third aspect of the present disclosure includes the battery module 2 according to the embodiment of the second aspect of the present disclosure.

As shown in FIG. 5, a vehicle 4 according to an embodiment of a fourth aspect of the present disclosure includes the battery pack 3 according to the embodiment of the third aspect of the present disclosure.

In the description of this specification, the description of the reference terms, such as "an embodiment", "some embodiments", "exemplary embodiments", "example", "specific example", or "some examples", means that the specific features, structures, materials, or characteristics described with reference to the embodiment or example are included in at least one embodiment or example of the present disclosure. In this specification, schematic descriptions of the foregoing terms do not necessarily indicate a same embodiment or example. Moreover, the specific features, structures, materials, or characteristics described may be combined in any one or more embodiments or examples in an appropriate manner.

Although the embodiments of the present disclosure have been shown and described, a person of ordinary skill in the art should understand that various changes, modifications, replacements, and variations may be made to the embodiments without departing from the principles and purposes of the present disclosure, and the scope of the present disclosure is as defined by the appended claims and their equivalents.

## Claims

1. An adapter module (1), comprising:
a support member (10);
a low-voltage plug member (20), arranged on the support member (10);
a sampling assembly (30), one end of the sampling assembly (30) being arranged on the support member (10), the one end of the sampling assembly (30) being electrically connected to the low-voltage plug member (20), the sampling assembly (30) being configured to perform voltage sampling and/or temperature sampling; and
an electrode lead-out piece (40), arranged on the support member (10), spaced apart from the low-voltage plug member (20), and electrically connected to the one end of the sampling assembly (30).

2. The adapter module (1) according to claim 1, wherein the electrode lead-out piece (40) is snap-fitted with the support member (10).

3. The adapter module (1) according to claim 2, wherein the support member (10) comprises an outer frame (11), a support body (12), and a positioning body (13), the support body (12) is arranged in a middle of the outer frame (11), the positioning body (13) is arranged at edges of the outer frame (11), and the positioning body (13) is located on two sides of the support body (12) respectively; and
the electrode lead-out piece (40) comprises a positive lead-out piece (41) and a negative lead-out piece (42), one portion of the positive lead-out piece (41) and one portion of the negative lead-out piece (42) are respectively positioning-fitted with the corresponding positioning body (13), and an other portion of the positive lead-out piece (41) and an other portion of the negative lead-out piece (42) is respectively snap-fitted with the two sides of the support body (12).

4. The adapter module (1) according to claim 3, wherein the electrode lead-out piece (40) further comprises an inner connecting piece (43), a connecting piece (44), and an outer connecting piece (45), the connecting piece (44) is bent and connected between the inner connecting piece (43) and the outer connecting piece (45), the outer connecting piece (45) is positioning-fitted with the positioning body (13), a first snap-connecting piece (46) is arranged on the inner connecting piece (43), and a second snap-connecting piece (14) is arranged on a side surface of the support body (11), the first snap-connecting piece (46) is snap-fitted with the second snap-connecting piece (14).

5. The adapter module (1) according to claim 4, wherein at least two first snap-connecting pieces (46) are provided, the at least two first snap-connecting pieces (46) are respectively located at two ends of the inner connecting piece (43) along a length direction, and at least two second snap-connecting pieces (14) are provided, the at least two second snap-connecting pieces (14) are snap-fitted with the at least two first snap-connecting pieces (46) in a one-to-one correspondence.

6. The adapter module (1) according to claim 4 or 5, wherein the first snap-connecting piece (46) is a snap groove arranged at an end of the inner connecting piece (43), and the second snap-connecting piece (14) is a snap protrusion arranged on a side surface of the support body (11), the snap protrusion is snap-fitted with the snap groove.

7. The adapter module (1) according to any one of claims 3 to 6, wherein a third snap-connecting piece (15) is arranged on a side surface of the support body (11), the third snap-connecting piece (15) is snap-connected to an end of the outer connecting piece (45) connected to the connecting piece (44).

8. The adapter module (1) according to claim 7, wherein a groove (16) is arranged on a side surface of the support body (11), and the third snap-connecting piece (15) is an elastic snap, the elastic snap is arranged in the groove (16).

9. The adapter module (1) according to any one of claims 3 to 8, wherein a first positioning piece (47) is arranged on the outer connecting piece (45), and a second positioning piece (17) is arranged on the positioning body (13), one of the first positioning piece (47) and the second positioning piece (17) being a positioning column, the other of the first positioning piece (47) and the second positioning piece (17) being a positioning hole, the positioning column fitting the positioning hole.

10. The adapter module (1) according to any one of claims 1 to 9, wherein the low-voltage plug member (20) and the support member (10) are integrally formed structural members; or
the support member (10) is arranged with a holder (18), the low-voltage plug member (20) is fixed to the holder (18).

11. The adapter module (1) according to any one of claims 1 to 10, wherein the sampling assembly (30) comprises a sampling line (31) and an electrical connection board (32), the electrical connection board (32) is arranged at an end of the sampling line (31), electrically connected to the low-voltage plug member (20), and further electrically connected to the electrode lead-out piece (40).

12. A battery module (2), comprising:
a plurality of battery cores (50), connected in series; and
the adapter module (1) according to any one of claims 1 to 11, the support member (10) being arranged at an end of the plurality of battery cores (50), the electrode lead-out piece (40) being connected to electrodes corresponding to battery cores (50) at a head end and a tail end respectively, and the sampling assembly (30) being arranged on one side of the plurality of battery cores (50), to perform voltage sampling and/or temperature sampling.

13. A battery pack (3), comprising the battery module (2) according to claim 12.

14. A vehicle (4), comprising the battery pack (3) according to claim 13.
